# EUROPEAN PATENT SPECIFICATION

(11) **EP 3 813 080 B1**
(45) Date of publication and mention of the grant of the patent: **04.06.2025**
(21) Application number: 19917532.4
(22) Date of filing: 20.09.2019
(51) Int. Cl.: H10F 77/20, C03C 3/074, C03C 8/10, C03C 8/16, C03C 8/18, H01B 1/16, H01B 1/22

(54) **PASTE FOR N-TYPE SOLAR CELL FRONT FINE GRIDS AND PREPARATION METHOD THEREFOR**
EINE ART FRONTFINGERPASTE FÜR N-SOLARZELLEN SOWIE VERFAHREN ZU IHRER HERSTELLUNG
PÂTE POUR GRILLES FINES AVANT DE CELLULE SOLAIRE DE TYPE N ET SON PROCÉDÉ DE PRÉPARATION

(30) Priority: 04.09.2019 CN 201910831615
(43) Date of publication of application: 28.04.2021
(73) Proprietor: NANTONG TIANSHENG NEW ENERGY CO., LTD., Economic And Technological Development Zone nantong, Jiangsu 226009 (CN)
(72) Inventor: ZHU, Peng, Jiangsu 226009 (CN); LIU, Yuan, Jiangsu 226009 (CN); LIU, Mengxue, Jiangsu 226009 (CN); WANG, Yeqing, Jiangsu 226009 (CN)
(74) Representative: Gong, Jinping
(86) International application number: PCT/CN2019/106899
(87) International publication number: WO 2021/042419

(56) References cited:
- EP-A1- 3 813 080
- CN-A- 102 194 898
- CN-A- 105 742 378
- CN-A- 105 789 343
- CN-A- 107 968 127
- CN-A- 108 022 672
- CN-A- 108 428 492
- CN-A- 110 040 968
- CN-A- 110 098 265
- CN-B- 103 177 790
- KR-B1- 101 693 840

## Description

### Technical Field

The invention relates to the field of polymer-based conductive materials, in particular to a type of front finger paste for N-type solar cells as well as its preparation methods.

### Background Technology

With the improvement of people's awareness of environmental protection, the development and utilization of clean energy are developing increasingly faster. Solar energy is inexhaustible and extremely abundant, making solar cells the focus of research and development in the field of new energy. Currently, most solar cells available in the market are P-type solar cells. However, N-type solar cells have a high conversion rate, low light-induced decay, good stability, high cost performance and other advantages. They are gradually attracting attention in the market. At the same time, N-type solar cells also have the double-sided power generation capability and are suitable for building integration and vertical installation. As a result, their application in the market is more and more favored by consumers.

However, N-type solar cells have higher processing difficulties and production costs despite higher efficiency, so their application is subject to certain restrictions. The most common N-type solar cell structure is composed of a p⁺ doped layer on the front side, an N-type silicon substrate, and an n⁺ doped layer on the back side. The cell's metallization generally adopts a double-sided H-type metal grid line structure, where the p⁺ side is printed with aluminum-doped silver paste and the n⁺ side is printed with silver paste. When the aluminum-doped silver paste is used on the front side, the solderability of the front side can be improved, but the presence of silver-aluminum speaks can increase the recombination possibility of the solar cell. If aluminum paste is used, the grid line will be unsmooth because aluminum is more active and has a lower melting point, resulting in the occurrence of aluminum beads or aluminum cladding in the grid line. In addition, in the existing technologies, most processes for printing fingers (fine grid lines) first make grooving and then make printing, such as Chinese patents CN201510207047.X and CN105742378A. Even if such a process is used, the process not only is complicated, but also can cause some damage to the passivation layer. In the case of laser grooving, additional process equipment is needed, which increases production costs. If aluminum paste, instead of the aluminum-doped silver paste, can be used to print fingers on the front side of the N-type solar cell, the production cost of the N-type solar cell can be greatly reduced. This will be beneficial to the mass promotion of N-type solar cells in the market. CN103177790B2 and

CN110040968A teach the use of silicon-aluminum alloy powder to improve the photoelectric conversion efficiency of solar cells.

### Content of the Invention

In order to solve the above-mentioned problems, the present invention first provides a type of front finger paste for N-type solar cells as specified in any of claims 1-8. By weight, the raw materials for the preparation of the paste include 1-5 parts of high-activity glass powder, 1-5 parts of silicon powder, 75-79 parts of aluminum-silicon alloy powder, and 15-20 parts of organic component.

The raw materials for the preparation of the above-mentioned high-activity glass powder include 5-20 parts of boric acid, 45-70 parts of lead oxide, 0-10 parts of lithium carbonate, 2-15 parts of zinc oxide, 0-10 parts of antimony trioxide, 5-30 parts of cesium carbonate, and 1-10 parts of silica.

As a preferred technical scheme, the silicon content in the above-mentioned aluminum-silicon alloy powder is 12-20wt%.

As a preferred technical scheme, the median particle size of the above-mentioned high-activity glass powder is 50-100 nanometers, the median particle size of silicon powder is 50-100 nanometers, and the median particle size of aluminum-silicon alloy powder is 1~3 microns.

As a preferred technical scheme, by weight, the raw materials for the preparation of the above-mentioned organic component include 3-5 parts of organic resin, 1-3 parts of binder, 2-4 parts of thixotropic agent, 1-3 parts of dispersant, and 5-8 parts of solvent.

As a preferred technical scheme, the above-mentioned organic resin is selected from one of acrylic resin, ethylene-vinyl acetate resin, alkyd resin, amino resin and epoxy resin, or the mixture of several of them.

As a preferred technical scheme, the above-mentioned binder is selected from one of ethyl cellulose, methyl cellulose and butyl cellulose, or the mixture of several of them.

As a preferred technical scheme, the above-mentioned thixotropic agent is selected from one of polyamide wax, hydrogenated castor oil, fumed silica and organic bentonite, or the mixture of several of them.

As a preferred technical scheme, the above-mentioned dispersant is selected from one of oleic acid, stearic acid, polyethylene glycol, tallowyl propylene diamine oleate, dimethyl adipate and phosphate trimesters, or the mixture of several of them.

Secondly, the present invention also provides a method for preparing the above-mentioned front finger paste for N-type solar cells as specified in claim 9. The method comprises the following steps: mix the organic component uniformly to obtain an organic mixture, then add the above-mentioned high-activity glass powder and silicon powder into the organic mixture and then disperse and mix them uniformly, and then add aluminum-silicon alloy powder into the resulting mixture and continue to disperse and mix them uniformly; and finally grind the resulting mixture in a three-roll machine to obtain the paste after the mixing is completed.

### Benefits:

1. The front finger paste for N-type solar cells and its preparation method provided by the present invention use aluminum paste to replace the aluminum-doped silver paste used in the existing technologies, thus reducing the production cost of N-type solar cells; and the high-activity glass powder contained in the aluminum paste can eliminate the grooving process before printing, thus simplifying the process steps, and it does not damage the passivation layer and can improve the electrical performance of the solar cell.
2. The present invention provides a type of front finger paste for N-type solar cells. The technical difficulty in preparing the front finger paste for N-type solar cells is: when the burn-through-type aluminum paste burns through the front side of a N-type solar cell, it is difficult to make the burn uniform while forming a good contact. The present invention solves this difficulty by the following solution: adding high-activity glass powder in the formula to facilitate burn-through, and also adding 1-5 parts of silicon powder in the formula. In the burn-through-type aluminum paste, the silicon powder is adsorbed on the surface of the aluminum paste to prevent the further reaction between the aluminum paste and the silicon substrate, thus making the burn more uniform. And by adding silicon powder in the formula, the content of silicon in the aluminum-silicon alloy powder increases. This enhances the melting point of the aluminum-silicon alloy powder, thereby reducing the corrosion effect on the silicon substrate.

### Embodiments

The content of the present invention can be further understood in combination with the following detailed description of preferred embodiment schemes as well as a lot of embodiment cases. Unless otherwise stated, all technical and scientific terms used herein have the same meaning as commonly understood by ordinary technicians in the technical field to which the present invention belongs. If the definition of a specific term disclosed in the existing technologies is inconsistent with its definition provided in the present invention, the definition of the term provided in the present invention shall prevail.

As used herein, unless the context clearly indicates otherwise, features that do not limit singular and plural forms are also intended to include plural features. It should also be understood that, as used herein, the term "be made of" is synonymous with "comprise", "include", "consist of", "have", "contain" and/or "be composed of". When such a term is used in the description of the present invention, it means the stated composition, step, method, product or device, but does not exclude the presence or addition of one or more other compositions, steps, methods, products or devices. In addition, in the description of the embodiment schemes of the present invention, the use of "preferred", "preferably", "more preferred" and other similar words refers to the embodiment schemes of the present invention that can provide certain beneficial effects under certain circumstances. However, under the same or other circumstances, other embodiment scheme may also be preferable. In addition, the description of one or more preferred embodiment schemes does not imply that other embodiment schemes are unavailable, and is not intended to exclude other embodiment schemes from the scope of the present invention, either.

In order to solve the above-mentioned problems, the present invention first provides a type of front finger paste for N-type solar cells. By weight, the raw materials for the preparation of the paste include 1-5 parts of high-activity glass powder, 1-5 parts of silicon powder, 75-79 parts of aluminum-silicon alloy powder, and 15-20 parts of organic component.

In some preferred embodiment schemes, the raw materials for preparing the above-mentioned front finger paste for N-type solar cells include 2-4 parts of high-activity glass powder, 2-4 parts of silicon powder, 77~79 parts of aluminum silicon alloy powder and 16-19 parts of organic component.

If the content of Al-Si alloy powder is less than 75 wt%, the viscosity of the prepared front finger paste will be too large and the plasticity of the front finger paste will be poor, resulting in wide grid lines and a large shading area during printing. This will lead to low photoelectric conversion efficiency. If the content of the Al-Si alloy powder is higher than 79wt%, the solid content of the prepared front finger paste will increase, resulting in poor printability.

In some preferred embodiment schemes, by weight, the raw materials for the preparation of the above-mentioned front finger paste for N-type solar cells include 3 parts of high-activity glass powder, 3 parts of silicon powder, 78 parts of aluminum-silicon alloy powder and 18 parts of organic component.

### High-activity glass powder

As an inorganic binder, the glass powder can etch the oxide layer on the surface of the aluminum powder during the high-temperature sintering process, and drive the aluminum powder particles to arrange on and adhere to the surface of the solar cell to form a dense conductive layer.

According to the invention, in parts by weight, the raw materials for the preparation of the above-mentioned high-activity glass powder include 5-20 parts of boric acid, 45-70 parts of lead oxide, 0-10 parts of lithium carbonate, 2-15 parts of zinc oxide, 0-10 parts of antimony trioxide, 5-30 parts of cesium carbonate, and 1-10 parts of silica.

In some preferred embodiment schemes, in parts by weight, the raw materials for the preparation of the above-mentioned high-activity glass powder include 12 parts of boric acid, 58 parts of lead oxide, 5 parts of lithium carbonate, 8 parts of zinc oxide, 5 parts of antimony trioxide, 18 parts of cesium carbonate, and 6 parts of silica.

The preparation method of the high-activity glass powder in the present invention is not particularly limited and can be any one which is well known to technicians in the technical field. For example, the mixed inorganic materials are completely melted into molten glass in a high-temperature furnace, and then the molten glass is poured into a rolling mill to make glass flakes, which are put into a ball mill and crushed into glass powder.

In some preferred embodiment schemes, the median particle size of the above-mentioned high-activity glass powder is 50-100 nanometers; further preferably, the median particle size of the above-mentioned high-activity glass powder is 80 nanometers.

The inventors of the present invention found that, compared with ordinary glass powder, the high-activity glass powder can react with the anti-reflection layer, making it unnecessary to use the conventional process of first grooving and then printing on the surface of the anti-reflection layer, thus avoiding the damage caused by the grooving on the polysilicon wafer and also greatly simplifying the process and reducing the cost. The reason for this is that, during the high-temperature sintering process, the lead oxide in the high-activity glass powder can react with silicon nitride and penetrate the passivation film, making the aluminum powder infiltrate into and form good contact with the silicon wafer, thus reducing the contact resistance between the finger and the silicon wafer. In addition, the silicon dioxide generated by the reaction can supplement the glass powder to further assist the arrangement and adhesion of the aluminum powder on the surface of the cell. There is the generated lead in the aluminum electrode. If such lead is oxidized into lead oxide, this can greatly increase the resistivity of the aluminum electrode. Antimony trioxide can be used as a catalyst in the lead oxidation process, thus reducing the content of lead oxide and making it further oxidized into lead dioxide. This ensures the lower contact resistance of the aluminum electrode. In addition, the addition of boron in the glass powder can dope silicon wafers. This can increase the charge carrier density to a certain extent. Zinc oxide can promote electron transport, and lithium and cesium are both the active metals of the first main family and can improve the activity of the glass powder and promote the reaction of the passivation layer.

### silicon powder

silicon powder is silica with extremely small particle size, and its synergistic effect with glass powder can appropriately lower the sintering temperature, reduce the sintering time and improve the sintering efficiency during the high-temperature sintering process. In the burn-through-type aluminum paste, silicon powder is adsorbed on the surface of the aluminum paste, preventing further reaction between the aluminum paste and the silicon substrate, and making the sintering more uniform. And by adding silicon powder in the formula, the content of silicon in the aluminum-silicon alloy powder increases. This enhances the melting point of the aluminum-silicon alloy powder, thereby reducing the corrosion effect on the silicon substrate.

In some preferred embodiment schemes, the median particle size of the above-mentioned silicon powder is 50-100 nanometers; further preferably, the median particle size of the above-mentioned silicon powder is 80 nanometers.

### Aluminum-silicon alloy powder

The aluminum-silicon alloy powder provides metal aluminum for the aluminum paste of the front finger of the solar cell, giving the finger (fine grid line) the function of conducting electricity and collecting charges. The existence of silicon can improve the compatibility of metal aluminum with the surface of the solar cell and increase its adhesion on the surface.

In some preferred embodiment schemes, the silicon content in the above-mentioned aluminum-silicon alloy powder is 12-20 wt%; further preferably, the silicon content in the above-mentioned aluminum-silicon alloy powder is 15 wt%.

In some preferred embodiment schemes, the median particle size of the above-mentioned aluminum-silicon alloy powder is 1 to 3 microns; further preferably, the median particle size of the above-mentioned aluminum-silicon alloy powder is 2 microns.

When the particle size of the Al-Si alloy powder is less than 1µm, safety problems are likely to occur during the production process and the explosion probability increases. When the particle size of the Al-Si alloy powder is greater than 3µm, the contact gap between the Al-Si alloy powder and the silicon substrate is large and the contact is uneven, resulting in large contact resistivity and increased local recombination.

In some preferred embodiment schemes, the weight ratio of the above-mentioned high-activity glass powder, silicon powder and aluminum-silicon alloy powder is 1: (0.5~1.5) : (25-27); further preferably, the weight ratio of the above-mentioned high-activity glass powder, silicon powder and aluminum-silicon alloy powder is 1:1:26.

The inventors of the present invention found that when high-activity glass powder, silicon powder and aluminum-silicon alloy powder are added into the formula in a certain ratio, a good electrode contact can be achieved, that is, the contact resistance is low and the requirements on the preparation process are reduced, and more energy and cost can thus be saved, due to the fact that within the preferred range, the reaction between the high-activity glass powder and the passivation layer can be controlled. On the one hand, such a ratio can help form a good contact between the aluminum powder and the silicon wafer; and on the other hand, it can make the silicon wafer locally doped. In addition, it does not cause any damage to the passivation layer and the silicon wafer, ensuring the stable electrical performance of the solar cell. The silicon powder supplements the silicon dioxide in the glass powder and improves the efficiency in the sintering step. With the assistance of high-activity glass powder and silicon powder, the aluminum-silicon alloy powder penetrates into the passivation layer to contact the silicon wafer; and the presence of silicon in the alloy reduces the contact among aluminum powder during the sintering process, that is, it reduces the appearance of aluminum beads. The inventors of the present invention found through a large number of experiments that when the weight ratio of high-activity glass powder, silicon powder and aluminum-silicon alloy powder is 1: (0.5~1.5) : (25~27), it not only can guarantee the electrical performance of the solar cell, but also can improve the preparation process and reduce energy consumption and cost. An excessive amount of silicon powder can lead to a reduction in the corrosion effect of the aluminum paste on the passivation layer, a decrease in the contact between aluminum powder and silicon wafer, and an increase in the contact resistance. This can reduce the electric conversion efficiency of the cell. Conversely, a too little amount of silicon powder can lead to a rise in the temperature required for sintering, an increase in energy consumption and a decrease in the adhesion of the printed finger to the cell's surface. When the amount of Al-Si alloy powder is excessive, the aluminum powder in the aluminum paste will be more likely to form beads, that is, small aluminum powder particles will shrink severely due to high-temperature sintering, thereby forming aluminum beads, resulting in a decrease in conductivity. On the contrary, when the amount of Al-Si alloy powder is too small, the content of aluminum powder will decrease and the conductivity will also reduce.

### Organic component

As the carrier of the paste, the organic component enables the aluminum powder and other solid substances to be evenly dispersed in them and to be stored stably, so as to produce high-performance fingers during the printing process.

In some preferred embodiment schemes, in parts by weight, the raw materials for the preparation of the above-mentioned organic component include 3-5 parts of organic resin, 1-3 parts of binder, 2-4 parts of thixotropic agent, 1-3 parts of dispersant and 5-8 parts of solvent; further preferably, the raw materials for the preparation of the above-mentioned organic component include 4 parts of organic resin, 2 parts of binder, 3 parts of thixotropic agent, 2 parts of dispersant and 6 parts of solvent.

In some preferred embodiment schemes, the above-mentioned organic resin is selected from one of acrylic resin, ethylene-vinyl acetate resin, alkyd resin, amino resin and epoxy resin, or the mixture of several of them; further preferably, the above-mentioned organic resin is acrylic resin.

In some preferred embodiment schemes, the above-mentioned acrylic resin is an acrylic resin solution with a mass concentration of 25-35%, and the solvent is terpineol; further preferably, the above-mentioned acrylic resin is an acrylic resin solution with a mass concentration of 30%, and the solvent is terpineol.

In some preferred embodiment schemes, the above-mentioned binder is selected from one of ethyl cellulose, methyl cellulose and butyl cellulose, or the mixture of several of them; further preferably, the above-mentioned binder is ethyl cellulose.

In some preferred embodiment schemes, the above-mentioned ethyl cellulose is the mixture of STD-type ethyl cellulose solution and N-type ethyl cellulose solution, and the solvent is terpineol.

In some preferred embodiment schemes, the weight ratio of the above-mentioned STD-type ethyl cellulose solution and the N-type ethyl cellulose solution is 1:1.

In some preferred embodiment schemes, the mass concentration of the above-mentioned STD-type ethyl cellulose solution is 15-25%, and the mass concentration of the above-mentioned N-type ethyl cellulose solution is 25-35%; further preferably, the mass concentration of the above-mentioned STD-type ethyl cellulose solution is 20%, and the mass concentration of the above-mentioned N-type ethyl cellulose solution is 30%.

In some preferred embodiment schemes, the relative molecular weight of the above-mentioned STD-type ethyl cellulose is 2000-5000; further preferably, the relative molecular weight of the above-mentioned STD-type ethyl cellulose is 3000.

In some preferred embodiment schemes, the relative molecular weight of the above-mentioned N-type ethyl cellulose is 500-2000; further preferably, the relative molecular weight of the above-mentioned N-type ethyl cellulose is 1000.

The STD-type ethyl cellulose used in the present invention was produced by DOW, and its brand name is STD10; the N-type ethyl cellulose was produced by Ashland and its brand name is N4.

In some preferred embodiment schemes, the above-mentioned thixotropic agent is selected from one of polyamide wax, hydrogenated castor oil, fumed silica and organic bentonite, or the mixture of several of them; further preferably, the above-mentioned thixotropic agent is polyamide wax.

In some preferred embodiment schemes, the above-mentioned polyamide wax is a polyamide wax solution with a mass concentration of 10-20%, and the solvent is terpineol; further preferably, the above-mentioned polyamide wax is a polyamide wax solution with a mass concentration of 15%, and the solvent is terpineol.

In some preferred embodiment schemes, the above-mentioned dispersant is selected from one of oleic acid, stearic acid, polyethylene glycol, tallowyl propylene diamine oleate, dimethyl adipate and phosphotriester, or the mixture of several of them; further preferably, the above-mentioned dispersant is the mixture of oleic acid and tallowyl propylene diamine oleate.

In some preferred embodiment schemes, the weight ratio of the above-mentioned oleic acid and tallowyl propylene diamine oleate is 1:3.

In some preferred embodiment schemes, the above-mentioned solvent is selected from one of butyl carbitol, terpineol, ethylene glycol ethyl ether acetate, diethylene glycol methyl ethyl ether and ethylene glycol dimethyl ether, or the mixture of several of them; further preferably, the above-mentioned solvent is butyl carbitol.

The inventors of the present invention found that all ingredients in the organic component are polar substances, which have certain compatibility with inorganic substances, and the presence of dispersants can further improve the uniform dispersion of inorganic powder in the organic carrier, so that the paste can keep its properties stable and have no lamination during the storage period and can produce high-performance fingers in subsequent printing steps. After high-temperature sintering, the organic phase in the aluminum paste volatilizes or decomposes, leaving fingers closely attached to the surface of the solar cell. Inside the fingers, aluminum powder is densely arranged.

On the second aspect, the present invention also provides a method for preparing the above-mentioned front finger paste for N-type solar cells, which includes the following steps: mix the organic component uniformly to obtain an organic mixture, then add the above-mentioned high-activity glass powder and silicon powder into the organic mixture and then disperse and mix them uniformly, and then add aluminum-silicon alloy powder into the resulting mixture and continue to disperse and mix them uniformly; and finally grind the resulting mixture in a three-roll machine to obtain the paste after the mixing is completed.

In some preferred embodiment schemes, the preparation method of the above-mentioned front finger paste for N-type solar cells includes the following steps: mix the organic component uniformly to obtain an organic mixture, then disperse the organic mixture at a rotation speed of 400-600rpm for 5~15s and at 900~1100rmp for 100~120s, then add high-activity glass powder and silicon powder into the mixture and disperse them at 400~600rpm for 5~15s and at 900~1100rpm for 100~120s, then add aluminum silicon alloy powder into the mixture and disperse them at 400~600rpm for 5-15s and at 900~1100rpm for 100-120s, and finally grind the resulting mixture for 2-5 times in a three-roll machine after the dispersion is completed.

In some preferred embodiment schemes, the preparation method of the above-mentioned front finger paste for N-type solar cells includes the following steps: mix the organic component uniformly to obtain an organic mixture, and then disperse the organic mixture at 500 rpm for 10s and at 1000 rpm for 110s, then add high-activity glass powder and silicon powder into the mixture and disperse them at 500rpm for 10s and at 1000rmp for 110s, then add Al-Si alloy powder into the mixture and disperse them at 500rmp for 10s and at 1000rmp for 110s, and finally grind the resulting mixture for 4 times in a three-roll machine after the dispersion is completed.

### Embodiment cases

The following embodiment cases illustrate the technical scheme of the present invention in detail, but the protection scope of the present invention is not limited to the embodiment cases. Unless otherwise specified, the raw materials used in the present invention are all commercially available.

### Embodiment 1:

Embodiment case 1 provides a type of front finger paste for N-type solar cells. In parts by weight, the raw materials for the preparation of the paste include 3 parts of high-activity glass powder, 3 parts of silicon powder, 78 parts of aluminum-silicon alloy powder and 18 parts of organic component.

In parts by weight, the raw materials for the preparation of the above-mentioned high-activity glass powder include 12 parts of boric acid, 58 parts of lead oxide, 5 parts of lithium carbonate, 8 parts of zinc oxide, 5 parts of antimony trioxide, 18 parts of cesium carbonate and 6 parts of silica.

The silicon content in the above-mentioned aluminum-silicon alloy powder is 15wt%.

The median particle size of the above-mentioned high-activity glass powder is 80 nanometers, the median particle size of silicon powder is 80 nanometers, and the median particle size of aluminum-silicon alloy powder is 2 microns.

In parts by weight, the raw materials for the preparation of the above-mentioned organic component include 4 parts of organic resin, 2 parts of binder, 3 parts of thixotropic agent, 2 parts of dispersant and 6 parts of solvent.

The above-mentioned organic resin is acrylic resin; the above-mentioned acrylic resin is an acrylic resin solution with a mass concentration of 30%, and the solvent is terpineol.

The above-mentioned binder is ethyl cellulose; the above-mentioned ethyl cellulose is the mixture of STD-type ethyl cellulose solution and N-type ethyl cellulose solution, with a mass ratio of 1:1; and the solvent is terpineol; the mass concentration of the above-mentioned STD-type ethyl cellulose solution is 20%, and the mass concentration of the N-type ethyl cellulose solution is 30%; the relative molecular weight of the above-mentioned STD-type ethyl cellulose is 3000, the relative molecular weight of the above-mentioned N-type ethyl cellulose is 1000.

The above-mentioned thixotropic agent is polyamide wax; the above-mentioned polyamide wax is a polyamide wax solution with a mass concentration of 15%, and the solvent is terpineol.

The above-mentioned dispersant is the mixture of oleic acid and tallowyl propylene diamine oleate; the weight ratio of the above-mentioned oleic acid and tallowyl propylene diamine oleate is 1:3.

The above-mentioned solvent is butyl carbitol.

This embodiment case also provides the preparation method of the aforementioned front finger paste for N-type solar cells, which includes the following steps: mix the organic component uniformly to obtain an organic mixture, then disperse the organic mixture at 500 rpm for 10 seconds and at 1000 rpm for 110 seconds, then add high-activity glass powder and silicon powder into the mixture and disperse them at 500rpm for 10s and at 1000rpm for 110s, and then add aluminum-silicon alloy powder into the mixture and disperse them at 500rpm for 10s and at 1000rpm for 110s**,** and finally grind the resulting mixture for 4 times in a three-roll machine after the dispersion is finished.

Let the prepared paste stand still at 80±2°C for 24 hours, then take it out and restore its temperature to room temperature, and then let it stand still at -20±2 °C for 24 hours, then take it out and restore its temperature to room temperature and observe the properties of the paste and see if there is any lamination to appear.

This embodiment case also provides a type of front finger for N-type solar cells. The finger is printed with the aforementioned front finger paste.

This embodiment case also provides a method for preparing the aforementioned front finger for N-type solar cells. The method includes the following steps: use the above-mentioned front finger paste for N-type solar cells to print fingers on the front of the solar cell, and dry the fingers at 255°C for 3 minutes after printing is completed, and then sinter them at 650°C, the peak sintering temperature, for 10 seconds.

Observe the printed fingers with naked eyes to see if their appearance is smooth and flat and if any aluminum beads appear. Test their contact resistivity. The result does not exceed 1.0 mΩ•cm².

### Embodiment 2:

Embodiment case 2 provides a type of front finger paste for N-type solar cells. In parts by weight, the raw materials for the preparation of the paste include 3 parts of high-activity glass powder, 3 parts of silicon powder, 78 parts of aluminum-silicon alloy powder and 18 parts of organic component.

In parts by weight, the raw materials for the preparation of the above-mentioned high-activity glass powder include 5 parts of boric acid, 45 parts of lead oxide, 2 parts of zinc oxide, 5 parts of cesium carbonate, and 1 part of silicon dioxide.

The silicon content in the above-mentioned aluminum-silicon alloy powder is 15wt%.

The median particle size of the above-mentioned high-activity glass powder is 80 nanometers, the median particle size of silicon powder is 80 nanometers, and the median particle size of aluminum-silicon alloy powder is 2 microns.

In parts by weight, the raw materials for the preparation of the above-mentioned organic component include 4 parts of organic resin, 2 parts of binder, 3 parts of thixotropic agent, 2 parts of dispersant and 6 parts of solvent.

The above-mentioned organic resin is acrylic resin; the above-mentioned acrylic resin is an acrylic resin solution with a mass concentration of 30%, and the solvent is terpineol.

The above-mentioned binder is ethyl cellulose; the above-mentioned ethyl cellulose is the mixture of STD-type ethyl cellulose solution and N-type ethyl cellulose solution, with a mass ratio of 1:1; and the solvent is terpineol; the mass concentration of the above-mentioned STD-type ethyl cellulose solution is 20%, and the mass concentration of the N-type ethyl cellulose solution is 30%; the relative molecular weight of the above-mentioned STD-type ethyl cellulose is 3000, the relative molecular weight of the above-mentioned N-type ethyl cellulose is 1000.

The above-mentioned thixotropic agent is polyamide wax; the above-mentioned polyamide wax is a polyamide wax solution with a mass concentration of 15%, and the solvent is terpineol.

The above-mentioned dispersant is the mixture of oleic acid and tallowyl propylene diamine oleate; the weight ratio of the above-mentioned oleic acid and tallowyl propylene diamine oleate is 1:3.

The above-mentioned solvent is butyl carbitol.

This embodiment case also provides the preparation method of the front finger paste for N-type solar cells, which is similar to Embodiment case 1.

Let the prepared paste stand still at 80±2°C for 24 hours, then take it out and restore its temperature to room temperature, and then let it stand still at -20±2 °C for 24 hours, then take it out and restore its temperature to room temperature and observe the properties of the paste and see if there is any lamination to appear.

This embodiment case also provides a type of front finger for N-type solar cells. The finger is printed with the aforementioned front finger paste.

This embodiment case also provides a method for preparing the aforementioned front finger of N-type solar cells, which is similar to Embodiment case 1.

Observe the printed fingers with naked eyes to see if their appearance is smooth and flat and if any aluminum beads appear. Test their contact resistivity. The result does not exceed 1.0 mΩ•cm².

### Embodiment 3:

Embodiment case 3 provides a type of front finger paste for N-type solar cells. In parts by weight, the raw materials for the preparation of the paste include 3 parts of high-activity glass powder, 3 parts of silicon powder, 78 parts of aluminum-silicon alloy powder and 18 parts of organic component.

In parts by weight, the raw materials for the preparation of the above-mentioned high-activity glass powder include 20 parts of boric acid, 70 parts of lead oxide, 10 parts of lithium carbonate, 15 parts of zinc oxide, 10 parts of antimony trioxide, 30 parts of cesium carbonate and 10 parts of silica.

The silicon content in the above-mentioned aluminum-silicon alloy powder is 15wt%.

The median particle size of the above-mentioned high-activity glass powder is 80 nanometers, the median particle size of silicon powder is 80 nanometers, and the median particle size of aluminum-silicon alloy powder is 2 microns.

In parts by weight, the raw materials for the preparation of the above-mentioned organic component include 4 parts of organic resin, 2 parts of binder, 3 parts of thixotropic agent, 2 parts of dispersant and 6 parts of solvent.

The above-mentioned organic resin is acrylic resin; the above-mentioned acrylic resin is an acrylic resin solution with a mass concentration of 30%, and the solvent is terpineol.

The above-mentioned binder is ethyl cellulose; the above-mentioned ethyl cellulose is the mixture of STD-type ethyl cellulose solution and N-type ethyl cellulose solution, with a mass ratio of 1:1; and the solvent is terpineol; the mass concentration of the above-mentioned STD-type ethyl cellulose solution is 20%, and the mass concentration of the N-type ethyl cellulose solution is 30%; the relative molecular weight of the above-mentioned STD-type ethyl cellulose is 3000, the relative molecular weight of the above-mentioned N-type ethyl cellulose is 1000.

The above-mentioned thixotropic agent is polyamide wax; the above-mentioned polyamide wax is a polyamide wax solution with a mass concentration of 15%, and the solvent is terpineol.

The above-mentioned dispersant is the mixture of oleic acid and tallowyl propylene diamine oleate; the weight ratio of the above-mentioned oleic acid and tallowyl propylene diamine oleate is 1:3.

The above-mentioned solvent is butyl carbitol.

This embodiment case also provides the preparation method of the front finger paste for N-type solar cells, which is similar to Embodiment case 1.

Let the prepared paste stand still at 80±2°C for 24 hours, then take it out and restore its temperature to room temperature, and then let it stand still at -20±2 °C for 24 hours, then take it out and restore its temperature to room temperature and observe the properties of the paste and see if there is any lamination to appear.

This embodiment case also provides a type of front finger for N-type solar cells. The finger is printed with the aforementioned front finger paste.

This embodiment case also provides a method for preparing the aforementioned front finger of N-type solar cells, which is similar to Embodiment case 1.

Observe the printed fingers with naked eyes to see if their appearance is smooth and flat and if any aluminum beads appear. Test their contact resistivity. The result does not exceed 1.0 mΩ•cm².

### Embodiment 4:

Embodiment case 4 provides a type of front finger paste for N-type solar cells. In parts by weight, the raw materials for the preparation of the paste include 1 parts of high-activity glass powder, 1 parts of silicon powder, 70 parts of aluminum-silicon alloy powder and 15 parts of organic component.

In parts by weight, the raw materials for the preparation of the above-mentioned high-activity glass powder include 12 parts of boric acid, 58 parts of lead oxide, 5 parts of lithium carbonate, 8 parts of zinc oxide, 5 parts of antimony trioxide, 18 parts of cesium carbonate and 6 parts of silica.

The silicon content in the above-mentioned aluminum-silicon alloy powder is 15wt%.

The median particle size of the above-mentioned high-activity glass powder is 80 nanometers, the median particle size of silicon powder is 80 nanometers, and the median particle size of aluminum-silicon alloy powder is 2 microns.

In parts by weight, the raw materials for the preparation of the above-mentioned organic component include 4 parts of organic resin, 2 parts of binder, 3 parts of thixotropic agent, 2 parts of dispersant and 6 parts of solvent.

The above-mentioned organic resin is acrylic resin; the above-mentioned acrylic resin is an acrylic resin solution with a mass concentration of 30%, and the solvent is terpineol.

The above-mentioned binder is ethyl cellulose. The above-mentioned ethyl cellulose is the mixture of STD-type ethyl cellulose solution and N-type ethyl cellulose solution at a mass ratio of 1:1, and the solvent is terpineol; the mass concentration of the above-mentioned STD-type ethyl cellulose solution is 20%, and the mass concentration of the N-type ethyl cellulose solution is 30%; the relative molecular weight of the above-mentioned STD-type ethyl cellulose is 3000, and the relative molecular weight of the above-mentioned N-type ethyl cellulose is 1000.

The above-mentioned thixotropic agent is polyamide wax; the above-mentioned polyamide wax is a polyamide wax solution with a mass concentration of 15%, and the solvent is terpineol.

The above-mentioned dispersant is the mixture of oleic acid and tallowyl propylene diamine oleate; the weight ratio of the above-mentioned oleic acid and tallowyl propylene diamine oleate is 1:3.

The above-mentioned solvent is butyl carbitol.

This embodiment case also provides the preparation method of the front finger paste for N-type solar cells, which is similar to Embodiment case 1.

Let the prepared paste stand still at 80±2°C for 24 hours, then take it out and restore its temperature to room temperature, and then let it stand still at -20±2 °C for 24 hours, then take it out and restore its temperature to room temperature and observe the properties of the paste and see if there is any lamination to appear.

This embodiment case also provides a type of front finger for N-type solar cells. The finger is printed with the aforementioned front finger paste.

This embodiment case also provides a method for preparing the aforementioned front finger of N-type solar cells, which is similar to Embodiment case 1.

Observe the printed fingers with naked eyes to see if their appearance is smooth and flat and if any aluminum beads appear. Test their contact resistivity. The result does not exceed 1.0 mΩ•cm².

### Embodiment 5:

Embodiment case 5 provides a type of front finger paste for N-type solar cells. In parts by weight, the raw materials for the preparation of the paste include 5 parts of high-activity glass powder, 5 parts of silicon powder, 85 parts of aluminum-silicon alloy powder and 20 parts of organic component.

In parts by weight, the raw materials for the preparation of the above-mentioned high-activity glass powder include 12 parts of boric acid, 58 parts of lead oxide, 5 parts of lithium carbonate, 8 parts of zinc oxide, 5 parts of antimony trioxide, 18 parts of cesium carbonate and 6 parts of silica.

The silicon content in the above-mentioned aluminum-silicon alloy powder is 15wt%.

The median particle size of the above-mentioned high-activity glass powder is 80 nanometers, the median particle size of silicon powder is 80 nanometers, and the median particle size of aluminum-silicon alloy powder is 2 microns.

In parts by weight, the raw materials for the preparation of the above-mentioned organic component include 4 parts of organic resin, 2 parts of binder, 3 parts of thixotropic agent, 2 parts of dispersant and 6 parts of solvent.

The above-mentioned organic resin is acrylic resin; the above-mentioned acrylic resin is an acrylic resin solution with a mass concentration of 30%, and the solvent is terpineol.

The above-mentioned binder is ethyl cellulose; the above-mentioned ethyl cellulose is the mixture of STD-type ethyl cellulose solution and N-type ethyl cellulose solution, with a mass ratio of 1:1; and the solvent is terpineol; the mass concentration of the above-mentioned STD-type ethyl cellulose solution is 20%, and the mass concentration of the N-type ethyl cellulose solution is 30%; the relative molecular weight of the above-mentioned STD-type ethyl cellulose is 3000, the relative molecular weight of the above-mentioned N-type ethyl cellulose is 1000.

The above-mentioned thixotropic agent is polyamide wax; the above-mentioned polyamide wax is a polyamide wax solution with a mass concentration of 15%, and the solvent is terpineol.

The above-mentioned dispersant is the mixture of oleic acid and tallowyl propylene diamine oleate; the weight ratio of the above-mentioned oleic acid and tallowyl propylene diamine oleate is 1:3.

The above-mentioned solvent is butyl carbitol.

This embodiment case also provides the preparation method of the front finger paste for N-type solar cells, which is similar to Embodiment case 1.

Let the prepared paste stand still at 80±2°C for 24 hours, then take it out and restore its temperature to room temperature, and then let it stand still at -20±2 °C for 24 hours, then take it out and restore its temperature to room temperature and observe the properties of the paste and see if there is any lamination to appear.

This embodiment case also provides a type of front finger for N-type solar cells. The finger is printed with the aforementioned front finger paste.

This embodiment case also provides a method for preparing the aforementioned front finger of N-type solar cells, which is similar to Embodiment case 1.

Observe the printed fingers with naked eyes to see if their appearance is smooth and flat and if any aluminum beads appear. Test their contact resistivity. The result does not exceed 1.0 mΩ•cm².

### Embodiment 6:

Embodiment case 6 provides a type of front finger paste for N-type solar cells. In parts by weight, the raw materials for the preparation of the paste include 3 parts of high-activity glass powder, 3 parts of silicon powder, 78 parts of aluminum-silicon alloy powder and 18 parts of organic component.

In parts by weight, the raw materials for the preparation of the above-mentioned high-activity glass powder include 12 parts of boric acid, 58 parts of lead oxide, 5 parts of lithium carbonate, 8 parts of zinc oxide, 5 parts of antimony trioxide, 18 parts of cesium carbonate and 6 parts of silica.

The silicon content in the above-mentioned aluminum-silicon alloy powder is 15wt%.

The median particle size of the above-mentioned high-activity glass powder is 80 nanometers, the median particle size of silicon powder is 80 nanometers, and the median particle size of aluminum-silicon alloy powder is 2 microns.

In parts by weight, the raw materials for the preparation of the above-mentioned organic component include 3 parts of organic resin, 1 parts of binder, 2 parts of thixotropic agent, 1 parts of dispersant and 5 parts of solvent.

The above-mentioned organic resin is acrylic resin; the above-mentioned acrylic resin is an acrylic resin solution with a mass concentration of 30%, and the solvent is terpineol.

The above-mentioned binder is ethyl cellulose; the above-mentioned ethyl cellulose is the mixture of STD-type ethyl cellulose solution and N-type ethyl cellulose solution, with a mass ratio of 1:1; and the solvent is terpineol; the mass concentration of the above-mentioned STD-type ethyl cellulose solution is 20%, and the mass concentration of the N-type ethyl cellulose solution is 30%; the relative molecular weight of the above-mentioned STD-type ethyl cellulose is 3000, the relative molecular weight of the above-mentioned N-type ethyl cellulose is 1000.

The above-mentioned thixotropic agent is polyamide wax; the above-mentioned polyamide wax is a polyamide wax solution with a mass concentration of 15%, and the solvent is terpineol.

The above-mentioned dispersant is the mixture of oleic acid and tallowyl propylene diamine oleate; the weight ratio of the above-mentioned oleic acid and tallowyl propylene diamine oleate is 1:3.

The above-mentioned solvent is butyl carbitol.

This embodiment case also provides the preparation method of the front finger paste for N-type solar cells, which is similar to Embodiment case 1.

Let the prepared paste stand still at 80±2°C for 24 hours, then take it out and restore its temperature to room temperature, and then let it stand still at -20±2 °C for 24 hours, then take it out and restore its temperature to room temperature and observe the properties of the paste and see if there is any lamination to appear.

This embodiment case also provides a type of front finger for N-type solar cells. The finger is printed with the aforementioned front finger paste.

This embodiment case also provides a method for preparing the aforementioned front finger of N-type solar cells, which is similar to Embodiment case 1.

Observe the printed fingers with naked eyes to see if their appearance is smooth and flat and if any aluminum beads appear. Test their contact resistivity. The result does not exceed 1.0 mΩ•cm².

### Embodiment 7:

Embodiment case 7 provides a type of front finger paste for N-type solar cells. In parts by weight, the raw materials for the preparation of the paste include 3 parts of high-activity glass powder, 3 parts of silicon powder, 78 parts of aluminum-silicon alloy powder and 18 parts of organic component.

In parts by weight, the raw materials for the preparation of the above-mentioned high-activity glass powder include 12 parts of boric acid, 58 parts of lead oxide, 5 parts of lithium carbonate, 8 parts of zinc oxide, 5 parts of antimony trioxide, 18 parts of cesium carbonate and 6 parts of silica.

The silicon content in the above-mentioned aluminum-silicon alloy powder is 15wt%.

The median particle size of the above-mentioned high-activity glass powder is 80 nanometers, the median particle size of silicon powder is 80 nanometers, and the median particle size of aluminum-silicon alloy powder is 2 microns.

In parts by weight, the raw materials for the preparation of the above-mentioned organic component include 5 parts of organic resin, 3 parts of binder, 4 parts of thixotropic agent, 3 parts of dispersant and 8 parts of solvent.

The above-mentioned organic resin is acrylic resin; the above-mentioned acrylic resin is an acrylic resin solution with a mass concentration of 30%, and the solvent is terpineol.

The above-mentioned binder is ethyl cellulose; the above-mentioned ethyl cellulose is the mixture of STD-type ethyl cellulose solution and N-type ethyl cellulose solution, with a mass ratio of 1:1; and the solvent is terpineol; the mass concentration of the above-mentioned STD-type ethyl cellulose solution is 20%, and the mass concentration of the N-type ethyl cellulose solution is 30%; the relative molecular weight of the above-mentioned STD-type ethyl cellulose is 3000, the relative molecular weight of the above-mentioned N-type ethyl cellulose is 1000.

The above-mentioned thixotropic agent is polyamide wax; the above-mentioned polyamide wax is a polyamide wax solution with a mass concentration of 15%, and the solvent is terpineol.

The above-mentioned dispersant is the mixture of oleic acid and tallowyl propylene diamine oleate; the weight ratio of the above-mentioned oleic acid and tallowyl propylene diamine oleate is 1:3.

The above-mentioned solvent is butyl carbitol.

This embodiment case also provides the preparation method of the front finger paste for N-type solar cells, which is similar to Embodiment case 1.

Let the prepared paste stand still at 80±2°C for 24 hours, then take it out and restore its temperature to room temperature, and then let it stand still at -20±2 °C for 24 hours, then take it out and restore its temperature to room temperature and observe the properties of the paste and see if there is any lamination to appear.

This embodiment case also provides a type of front finger for N-type solar cells. The finger is printed with the aforementioned front finger paste.

This embodiment case also provides a method for preparing the aforementioned front finger of N-type solar cells, which is similar to Embodiment case 1.

Observe the printed fingers with naked eyes to see if their appearance is smooth and flat and if any aluminum beads appear. Test their contact resistivity. The result does not exceed 1.0 mΩ•cm².

### Embodiment 8:

Embodiment case 8 provides a type of front finger paste for N-type solar cells. In parts by weight, the raw materials for preparing the paste include 3 parts of high-activity glass powder, 3 parts of silicon powder, 78 parts of aluminum and 18 parts of organic component.

In parts by weight, the raw materials for the preparation of the above-mentioned high-activity glass powder include 12 parts of boric acid, 58 parts of lead oxide, 5 parts of lithium carbonate, 8 parts of zinc oxide, 5 parts of antimony trioxide, 18 parts of cesium carbonate and 6 parts of silica.

The median particle size of the above-mentioned high-activity glass powder is 80 nanometers, the median particle size of silicon powder is 80 nanometers, and the median particle size of aluminum powder is 2 microns.

In parts by weight, the raw materials for the preparation of the above-mentioned organic component include 4 parts of organic resin, 2 parts of binder, 3 parts of thixotropic agent, 2 parts of dispersant and 6 parts of solvent.

The above-mentioned organic resin is acrylic resin; the above-mentioned acrylic resin is an acrylic resin solution with a mass concentration of 30%, and the solvent is terpineol.

The above-mentioned binder is ethyl cellulose; the above-mentioned ethyl cellulose is the mixture of STD-type ethyl cellulose solution and N-type ethyl cellulose solution, with a mass ratio of 1:1; and the solvent is terpineol; the mass concentration of the above-mentioned STD-type ethyl cellulose solution is 20%, and the mass concentration of the N-type ethyl cellulose solution is 30%; the relative molecular weight of the above-mentioned STD-type ethyl cellulose is 3000, the relative molecular weight of the above-mentioned N-type ethyl cellulose is 1000.

The above-mentioned thixotropic agent is polyamide wax; the above-mentioned polyamide wax is a polyamide wax solution with a mass concentration of 15%, and the solvent is terpineol.

The above-mentioned dispersant is the mixture of oleic acid and tallowyl propylene diamine oleate; the weight ratio of the above-mentioned oleic acid and tallowyl propylene diamine oleate is 1:3.

The above-mentioned solvent is butyl carbitol.

This embodiment case also provides the preparation method of the front finger paste for N-type solar cells, which is similar to Embodiment case 1.

Let the prepared paste stand still at 80±2°C for 24 hours, then take it out and restore its temperature to room temperature, and then let it stand still at -20±2 °C for 24 hours, then take it out and restore its temperature to room temperature and observe the properties of the paste and see if there is any lamination to appear.

This embodiment case also provides a type of front finger for N-type solar cells. The finger is printed with the aforementioned front finger paste.

This embodiment case also provides a method for preparing the aforementioned front finger of N-type solar cells, which is similar to Embodiment case 1.

Observe the printed finger with naked eyes to see if any aluminum beads appear in the outer appearance of the finger. Test their contact resistivity. The result exceeds 1.0 mΩ•cm².

### Embodiment 9:

Embodiment case 9 provides a type of front finger paste for N-type solar cells. **In** parts by weight, the raw materials for the preparation of the paste include 3 parts of high-activity glass powder, 3 parts of silicon powder, 78 parts of aluminum-silicon alloy powder and 18 parts of organic component.

In parts by weight, the raw materials for the preparation of the above-mentioned high-activity glass powder include 12 parts of boric acid, 58 parts of lead oxide, 5 parts of lithium carbonate, 8 parts of zinc oxide, 5 parts of antimony trioxide, 18 parts of cesium carbonate and 6 parts of silica.

The silicon content in the above-mentioned aluminum-silicon alloy powder is 12wt%.

The median particle size of the above-mentioned high-activity glass powder is 80 nanometers, the median particle size of silicon powder is 80 nanometers, and the median particle size of aluminum-silicon alloy powder is 2 microns.

In parts by weight, the raw materials for the preparation of the above-mentioned organic component include 4 parts of organic resin, 2 parts of binder, 3 parts of thixotropic agent, 2 parts of dispersant and 6 parts of solvent.

The above-mentioned organic resin is acrylic resin; the above-mentioned acrylic resin is an acrylic resin solution with a mass concentration of 30%, and the solvent is terpineol.

The above-mentioned binder is ethyl cellulose; the above-mentioned ethyl cellulose is the mixture of STD-type ethyl cellulose solution and N-type ethyl cellulose solution, with a mass ratio of 1:1; and the solvent is terpineol; the mass concentration of the above-mentioned STD-type ethyl cellulose solution is 20%, and the mass concentration of the N-type ethyl cellulose solution is 30%; the relative molecular weight of the above-mentioned STD-type ethyl cellulose is 3000, the relative molecular weight of the above-mentioned N-type ethyl cellulose is 1000.

The above-mentioned thixotropic agent is polyamide wax; the above-mentioned polyamide wax is a polyamide wax solution with a mass concentration of 15%, and the solvent is terpineol.

The above-mentioned dispersant is the mixture of oleic acid and tallowyl propylene diamine oleate; the weight ratio of the above-mentioned oleic acid and tallowyl propylene diamine oleate is 1:3.

The above-mentioned solvent is butyl carbitol.

This embodiment case also provides the preparation method of the front finger paste for N-type solar cells, which is similar to Embodiment case 1.

Let the prepared paste stand still at 80±2°C for 24 hours, then take it out and restore its temperature to room temperature, and then let it stand still at -20±2 °C for 24 hours, then take it out and restore its temperature to room temperature and observe the properties of the paste and see if there is any lamination to appear.

This embodiment case also provides a type of front finger for N-type solar cells. The finger is printed with the aforementioned front finger paste.

This embodiment case also provides a method for preparing the aforementioned front finger of N-type solar cells, which is similar to Embodiment case 1.

Observe the printed fingers with naked eyes to see if their appearance is smooth and flat and if any aluminum beads appear. Test their contact resistivity. The result does not exceed 1.0 mΩ•cm².

### Embodiment 10:

Embodiment case 10 provides a type of front finger paste for N-type solar cells. In parts by weight, the raw materials for the preparation of the paste include 3 parts of high-activity glass powder, 3 parts of silicon powder, 78 parts of aluminum-silicon alloy powder and 18 parts of organic component.

In parts by weight, the raw materials for the preparation of the above-mentioned high-activity glass powder include 12 parts of boric acid, 58 parts of lead oxide, 5 parts of lithium carbonate, 8 parts of zinc oxide, 5 parts of antimony trioxide, 18 parts of cesium carbonate and 6 parts of silica.

The silicon content in the above-mentioned aluminum-silicon alloy powder is 20wt%.

The median particle size of the above-mentioned high-activity glass powder is 80 nanometers, the median particle size of silicon powder is 80 nanometers, and the median particle size of aluminum-silicon alloy powder is 2 microns.

In parts by weight, the raw materials for the preparation of the above-mentioned organic component include 4 parts of organic resin, 2 parts of binder, 3 parts of thixotropic agent, 2 parts of dispersant and 6 parts of solvent.

The above-mentioned organic resin is acrylic resin; the above-mentioned acrylic resin is an acrylic resin solution with a mass concentration of 30%, and the solvent is terpineol.

The above-mentioned binder is ethyl cellulose; the above-mentioned ethyl cellulose is the mixture of STD-type ethyl cellulose solution and N-type ethyl cellulose solution, with a mass ratio of 1:1; and the solvent is terpineol; the mass concentration of the above-mentioned STD-type ethyl cellulose solution is 20%, and the mass concentration of the N-type ethyl cellulose solution is 30%; the relative molecular weight of the above-mentioned STD-type ethyl cellulose is 3000, the relative molecular weight of the above-mentioned N-type ethyl cellulose is 1000.

The above-mentioned thixotropic agent is polyamide wax; the above-mentioned polyamide wax is a polyamide wax solution with a mass concentration of 15%, and the solvent is terpineol.

The above-mentioned dispersant is the mixture of oleic acid and tallowyl propylene diamine oleate; the weight ratio of the above-mentioned oleic acid and tallowyl propylene diamine oleate is 1:3.

The above-mentioned solvent is butyl carbitol.

This embodiment case also provides the preparation method of the front finger paste for N-type solar cells, which is similar to Embodiment case 1.

Let the prepared paste stand still at 80±2°C for 24 hours, then take it out and restore its temperature to room temperature, and then let it stand still at -20±2 °C for 24 hours, then take it out and restore its temperature to room temperature and observe the properties of the paste and see if there is any lamination to appear.

This embodiment case also provides a type of front finger for N-type solar cells. The finger is printed with the aforementioned front finger paste.

This embodiment case also provides a method for preparing the aforementioned front finger of N-type solar cells, which is similar to Embodiment case 1.

Observe the printed fingers with naked eyes to see if their appearance is smooth and flat and if any aluminum beads appear. Test their contact resistivity. The result does not exceed 1.0 mΩ•cm².

## Claims

1. A type of front finger paste for N-type solar cells, which is **characterized by** that, in parts by weight, the raw materials for preparing it include 1-5 parts of high-activity glass powder, 1-5 parts of silicon powder, 75-79 parts of aluminum-silicon alloy powder and 15-20 parts of organic component;
**characterized by** that, in parts by weight, the raw materials for preparing the above-mentioned high-activity glass powder include 5-20 parts of boric acid, 45-70 parts of lead oxide, 0-10 parts of lithium carbonate, 2-15 parts of zinc oxide, 0-10 parts of antimony trioxide, 5-30 parts of cesium carbonate, and 1-10 parts of silicon dioxide.

2. The front finger paste for N-type solar cells described in Claim 1, which is **characterized by** that, the silicon content in the above-mentioned aluminum-silicon alloy powder is 12-20 wt%.

3. The front finger paste for N-type solar cells described in any one of claims 1-2, which is **characterized by** that, the median particle size of the above-mentioned high activity glass powder is 50-100 nanometers, and the median particle size of silicon powder is 50-100 nanometers, and the median particle size of the aluminum-silicon alloy powder is 1-3 microns.

4. The front finger paste for N-type solar cells described in Claim 1, which is **characterized by** that, in parts by weight, the raw materials for preparing the above-mentioned organic component include 3-5 parts of organic resin, 1-3 parts of binder, and 2-4 parts of thixotropic agent, 1-3 parts of dispersant, and 5-8 parts of solvent.

5. The front finger paste for N-type solar cells described in Claim 4, which is **characterized by** that, the above-mentioned organic resin is selected from one of acrylic resin, ethylene-vinyl acetate resin, alkyd resin, amino resin and epoxy resin, or the mixture of several of them.

6. The front finger paste for N-type solar cells described in Claim 4, which is **characterized by** that, the above-mentioned binder is selected from one of ethyl cellulose, methyl cellulose and butyl cellulose, or the mixture of several of them.

7. The front finger paste for N-type solar cells described in Claim 4, which is **characterized by** that, the above-mentioned thixotropic agent is selected from one of polyamide wax, hydrogenated castor oil, fumed silica and organic bentonite, or the mixture of several of them.

8. The front finger paste for N-type solar cells described in Claim 4, which is **characterized by** that, the above-mentioned dispersant is selected from one of oleic acid, stearic acid, polyethylene glycol, tallowyl propylene diamine oleate, and phosphate triester, or the mixture of several of them.

9. A method for preparing the front finger paste for N-type solar cells described in any one of Claims 1-8, which is **characterized by** that, it comprises the following steps: mix the organic component uniformly to obtain an organic mixture, then add the above-mentioned high-activity glass powder and silicon powder into the organic mixture and then disperse and mix them uniformly, and then add aluminum-silicon alloy powder into the resulting mixture and continue to disperse and mix them uniformly; and finally grind the resulting mixture in a three-roll machine to obtain the paste after the mixing is completed.

## Patentansprüche

1. Frontfingerpaste für N-Typ-Solarzellen, **dadurch gekennzeichnet, dass** die Rohstoffe für ihre Herstellung, in Gewichtsteilen, 1 bis 5 Teile hochaktives Glaspulver, 1 bis 5 Teile Siliziumpulver, 75 bis 79 Teile Aluminium-Silizium-Legierungspulver und 15 bis 20 Teile organische Komponente umfassen,
**dadurch gekennzeichnet, dass** die Rohstoffe zur Herstellung des oben genannten hochaktiven Glaspulvers, in Gewichtsteilen, 5 bis 20 Teile Borsäure, 45 bis 70 Teile Bleioxid, 0 bis 10 Teile Lithiumcarbonat, 2 bis 15 Teile Zinkoxid, 0 bis 10 Teile Antimontrioxid, 5 bis 30 Teile Cesiumcarbonat und 1 bis 10 Teile Siliziumdioxid umfassen.

2. Frontfingerpaste für N-Typ-Solarzellen nach Anspruch 1, **dadurch gekennzeichnet, dass** der Siliziumgehalt im oben genannten Aluminium-Silizium-Legierungspulver 12 bis 20 Gew.-% beträgt.

3. Frontfingerpaste für N-Typ-Solarzellen nach einem der Ansprüche 1 bis 2, **dadurch gekennzeichnet, dass** die mittlere Partikelgröße des oben genannten hochaktiven Glaspulvers 50 bis 100 Nanometer, die mittlere Partikelgröße des Siliziumpulvers 50 bis 100 Nanometer und die mittlere Partikelgröße des Aluminium-Silizium-Legierungspulvers 1 bis 3 Mikrometer beträgt.

4. Frontfingerpaste für N-Typ-Solarzellen nach Anspruch 1, **dadurch gekennzeichnet, dass** die Rohstoffe zur Herstellung der oben genannten organischen Komponente, in Gewichtsteilen, 3 bis 5 Teile organisches Harz, 1 bis 3 Teile Bindemittel, 2 bis 4 Teile Thixotropiermittel, 1 bis 3 Teile Dispergiermittel und 5 bis 8 Teile Lösungsmittel umfassen.

5. Frontfingerpaste für N-Typ-Solarzellen nach Anspruch 4, **dadurch gekennzeichnet, dass** das oben genannte organische Harz ausgewählt ist aus einem von Acrylharz, Ethylen-Vinylacetat-Harz, Alkydharz, Aminoharz und Epoxidharz oder einer Mischung aus mehreren davon.

6. Frontfingerpaste für N-Typ-Solarzellen nach Anspruch 4, **dadurch gekennzeichnet, dass** das oben genannte Bindemittel ausgewählt ist aus einem von Ethylcellulose, Methylcellulose und Butylcellulose oder einer Mischung aus mehreren davon.

7. Frontfingerpaste für N-Typ-Solarzellen nach Anspruch 4, **dadurch gekennzeichnet, dass** das oben genannte Thixotropiermittel ausgewählt ist aus einem von Polyamidwachs, hydriertem Rizinusöl, pyrogenem Siliciumdioxid und organischem Bentonit oder der Mischung mehrerer davon.

8. Frontfingerpaste für N-Typ-Solarzellen nach Anspruch 4, **dadurch gekennzeichnet, dass** das oben genannte Dispergiermittel ausgewählt ist aus einem von Ölsäure, Stearinsäure, Polyethylenglykol, Talgpropylendiaminoleat und Phosphattriester oder der Mischung mehrerer davon.

9. Verfahren zur Herstellung der Frontfingerpaste für N-Typ-Solarzellen nach einem der Ansprüche 1 bis 8, **dadurch gekennzeichnet, dass** es die folgenden Schritte umfasst: gleichmäßiges Mischen der organischen Komponente, um eine organische Mischung zu erhalten, anschließendes Hinzufügen des oben genannten hochaktiven Glaspulvers und Siliziumpulvers zu der organischen Mischung und anschließendes gleichmäßiges Dispergieren und Mischen derselben, anschließendes Hinzufügen von Aluminium-Silizium-Legierungspulver zu der resultierenden Mischung und fortgesetztes gleichmäßiges Dispergieren und Mischen derselben; und abschließendes Mahlen der resultierenden Mischung in einer Dreiwalzenmühle, um die Paste nach Abschluss des Mischens zu erhalten.

## Revendications

1. Un type de pâte de doigt avant pour cellules solaires de type N, **caractérisé en ce que**, en parties en poids, les matières premières pour la préparation comprennent 1 à 5 parties de poudre de verre à haute activité, 1 à 5 parties de poudre de silicium, 75 à 79 parties de poudre d'alliage aluminium-silicium et 15 à 20 parties de composant organique ;
**caractérisé en ce que**, en parties en poids, les matières premières pour préparer la poudre de verre à haute activité mentionnée ci-dessus comprennent 5 à 20 parties d'acide borique, 45 à 70 parties d'oxyde de plomb, 0 à 10 parties de carbonate de lithium, 2 à 15 parties d'oxyde de zinc, 0 à 10 parties de trioxyde d'antimoine, 5 à 30 parties de carbonate de césium et 1 à 10 parties de dioxyde de silicium.

2. La pâte de doigt avant pour cellules solaires de type N décrite dans la revendication 1, **caractérisée en ce que** la teneur en silicium dans la poudre d'alliage aluminium-silicium mentionnée ci-dessus est de 12 à 20 % en poids.

3. La pâte de doigt avant pour cellules solaires de type N décrite dans l'une quelconque des revendications 1 à 2, **caractérisée en ce que** la taille médiane des particules de la poudre de verre à haute activité mentionnée ci-dessus est de 50 à 100 nanomètres, et la taille médiane des particules de poudre de silicium est de 50 à 100 nanomètres, et la taille médiane des particules de la poudre d'alliage aluminium-silicium est de 1 à 3 microns.

4. La pâte de doigt avant pour cellules solaires de type N décrite dans la revendication 1, **caractérisée en ce que**, en parties en poids, les matières premières pour préparer le composant organique mentionné ci-dessus comprennent 3 à 5 parties de résine organique, 1 à 3 parties de liant, et 2 à 4 parties d'agent thixotrope, 1 à 3 parties de dispersant, et 5 à 8 parties de solvant.

5. La pâte pour doigt avant pour cellules solaires de type N décrite dans la revendication 4, **caractérisée en ce que** la résine organique mentionnée ci-dessus est choisie parmi une résine acrylique, une résine éthylène-acétate de vinyle, une résine alkyde, une résine aminée et une résine époxy, ou un mélange de plusieurs d'entre elles.

6. La pâte de doigt avant pour cellules solaires de type N décrite dans la revendication 4, **caractérisée en ce que** le liant mentionné ci-dessus est choisi parmi l'éthylcellulose, la méthylcellulose et la butylcellulose, ou un mélange de plusieurs d'entre elles.

7. La pâte de doigt avant pour cellules solaires de type N décrite dans la revendication 4, **caractérisée en ce que** l'agent thixotrope mentionné ci-dessus est choisi parmi la cire de polyamide, l'huile de ricin hydrogénée, la silice fumée et la bentonite organique, ou le mélange de plusieurs d'entre eux.

8. La pâte de doigt avant pour cellules solaires de type N décrite dans la revendication 4, **caractérisée en ce que** le dispersant mentionné ci-dessus est choisi parmi l'acide oléique, l'acide stéarique, le polyéthylène glycol, l'oléate de diamine propylène tallowyl et le triester de phosphate, ou le mélange de plusieurs d'entre eux.

9. Un procédé de préparation de la pâte de doigt avant pour cellules solaires de type N décrite dans l'une quelconque des revendications 1 à 8, **caractérisé en ce qu'**il comprend les étapes suivantes : mélanger le composant organique uniformément pour obtenir un mélange organique, puis ajouter la poudre de verre à haute activité et la poudre de silicium mentionnées ci-dessus dans le mélange organique, puis les disperser et les mélanger uniformément, puis ajouter la poudre d'alliage aluminium-silicium dans le mélange résultant et continuer à les disperser et les mélanger uniformément ; et enfin broyer le mélange résultant dans une machine à trois rouleaux pour obtenir la pâte une fois le mélange terminé.
